# EUROPÄISCHE PATENTSCHRIFT

(11) **EP 2 912 206 B1**
(45) Veröffentlichungstag und Bekanntmachung des Hinweises auf die Patenterteilung: **21.09.2016**
(21) Anmeldenummer: 13807895.1
(22) Anmeldetag: 23.10.2013
(51) Int. Cl.: C23C 14/06, C23C 14/32, C23C 30/00

(54) **BAUTEIL MIT EINER BESCHICHTUNG UND VERFAHREN ZU SEINER HERSTELLUNG**
COMPONENT HAVING A COATING AND METHOD FOR THE PRODUCTION THEREOF
COMPOSANT DOTÉ D'UN REVÊTEMENT ET PROCÉDÉ POUR LE FABRIQUER

(30) Priorität: 23.10.2012 DE 102012020757
(43) Veröffentlichungstag der Anmeldung: 02.09.2015
(73) Patentinhaber: MAHLE International GmbH, 70376 Stuttgart (DE)
(72) Erfinder: LEHNERT, Monika, 71686 Remseck (DE); MAIER, Kurt, 71229 Leonberg (DE)
(74) Vertreter: BRP Renaud & Partner mbB Rechtsanwälte Patentanwälte Steuerberater
(86) Internationale Anmeldenummer: PCT/DE2013/000625
(87) Internationale Veröffentlichungsnummer: WO 2014/063676

(56) Entgegenhaltungen:
- WO-A2-2007/115419
- DE-A1-102008 062 220

## Beschreibung

Die vorliegende Erfindung betrifft ein Bauteil mit einer Chrom, Stickstoff und Kohlenstoff enthaltenden Beschichtung.

Beschichtungen aus Chromnitrid, erzeugt mit PVD-Verfahren mit Lichtbogenverdampfung, sind dem Fachmann bekannt. Sie finden bspw. Verwendung auf Bauteilen für Verbrennungsmotoren, insbesondere für Dieselmotoren. Diese Beschichtungen zeigen eine gute Verschleißbeständigkeit und sind bei den im Motorbetrieb am Bauteil herrschenden Temperaturen thermisch stabil.

Ein wichtiges Ziel bei der Entwicklung von Verbrennungsmotoren ist die weitere Reduzierung des Kraftstoffverbrauchs. Hierfür müssen - neben einer Vielzahl anderer Maßnahmen - die Reibungsverluste innerhalb des Verbrennungsmotors verringert werden. Unter anderem wird angestrebt, die Reibung zwischen den Laufflächen der Kolbenringe und der Zylinderlauffläche im Motorbetrieb zu minimieren.

In der DE 10 2008 042 747 A1 ist zur Verminderung der Reibung eine Kohlenstoffbeschichtung vom Typ a-C:H offenbart. Infolge ihres Gehalts an Wasserstoff sind derartige Beschichtungen jedoch bis höchstens 300°C stabil. Insbesondere in Dieselmotoren sind die Oberflächentemperaturen der direkt dem Brennraum zugeordneten obersten Kolbenringe deutlich höher. Die a-C:H-Schichten zersetzen sich bei Temperaturen über 300°C durch Abgabe von Wasserstoff. Der zurückbleibende Kohlenstoff graphitisiert und wird rasch abrasiv verschlissen. Derartige Beschichtungen können daher nur als Einlaufschichten eingesetzt werden, nicht jedoch als dauerhaltbare Schichten.

In der US 5,449,547 A ist die Zugabe von Kohlenstoff zu Beschichtungen aus Chromnitrid beschrieben. Dabei soll Kohlenstoff in fester Lösung eingelagert sein. Das bedeutet, dass Kohlenstoff keine eigene Phase bildet, sondern interstitiell im CrN-Gitter eingelagert ist. Die Zugabe von Kohlenstoff soll die mechanischen Eigenschaften der Schicht verbessern, insbesondere die Zähigkeit. Eine Verbesserung der Reibung ist nicht bezweckt und so auch nicht möglich.

Die WO 2007/115419 offenbart die Abscheidung eines mehrphasigen Schichtwerkstoffes mittels PVD-Lichtbogenverfahren. Dabei kann der Schichtwerkstoff aus Chromcarbid und Kohlenstoff bzw. aus Chromcarbonitrid und Kohlenstoff bestehen, allerdings mit einem Gesamtkohlenstoffanteil von mehr als 20 Atom-%. Derartige Schichten weisen zwar eine geringe Reibung auf, sind jedoch aufgrund ihres hohen Kohlenstoff-Anteils mechanisch relativ instabil und verschleißen daher rasch.

Eine zweiphasige Kolbenringbeschichtung, bestehend aus Chromcarbid und Kohlenstoff, ist auch in DE 10 2008 062 220 A1 beschrieben. Dabei soll der Anteil an Chromcarbiden maximal 80 Atom-% betragen. Der Rest ist freier Kohlenstoff, der in Form von Graphit als separate Phase vorliegt. Die leichte Spaltbarkeit von Graphit führt ebenfalls zu Problemen hinsichtlich der mechanischen Stabilität.

Die Aufgabe der vorliegenden Erfindung besteht darin, ein gattungsgemäßes Bauteil so weiterzuentwickeln, dass seine Beschichtung zu einer Reduzierung der Reibung beiträgt, ohne die Verschleißbeständigkeit und die thermische Belastbarkeit zu beeinträchtigen.

Die Lösung besteht darin, dass die Beschichtung eine Gleitschicht mit einer keramischen Phase und einer amorphe Phase aufweist, dass die keramische Phase eine kristalline keramische Matrix aus Crₓ(C_{1-y}N_{y}) mit 0,8 ≤ x ≤ 1,2 und y > 0,7 bildet, und dass die amorphe Phase aus Kohlenstoffpartikeln besteht, die in die kristalline keramische Matrix im Wesentlichen gleichmäßig verteilt eingelagert sind.

Gegenstand der Erfindung ist ferner ein Verfahren zum Beschichten eines Bauteils mit einer Gleitschicht mit einer keramischen Phase und einer amorphen Phase, wobei mindestens ein Bauteil in einer Vakuumkammer drehbar auf einer auf einem Drehtisch angeordneten Spindel montiert ist. Erfindungsgemäß wird die Gleitschichtdurch ein PVD-Verfahren mit Lichtbogenverdampfung aufgetragen, wobei die folgenden Parameter verwendet werden. Als Werkstoffquellen dienen mindestens ein Metalltarget und mindestens ein Kohlenstofftarget, wobei das Verhältnis der Targetströme von Metall zu Kohlenstoff 7 bis 13 beträgt. Die Abscheidetemperatur am Bauteil beträgt 350°C bis 450°C. Die Biasspannung beträgt 0 bis -100 V. Der Druck in der Vakuumkammer beträgt 2 - 4 Pa. Die Atmosphäre in der Vakuumkammer setzt sich aus Stickstoff und Inertgas mit einem Verhältnis des Stickstoffpartialdrucks zum Gesamtdruck von 0,55 bis 0,75 zusammen. Während des Beschichtungsvorgangs beträgt die Rotation des Drehtisches 20 - 40 Umdrehungen pro Minute, während die Rotation der mindestens einen Spindel 5 - 7 Umdrehungen pro einer Umdrehung des Drehtischs beträgt.

Die keramische Phase in Form einer kristallinen keramischen Matrix bewirkt einen hohen Verschleißwiderstand der Beschichtung des erfindungsgemäßen Bauteils, während die amorphe Phase in Form von Kohlenstoffpartikeln dank ihrer selbstschmierenden Eigenschaft eine Reduzierung der Reibung bewirkt.

Beide Phasen sind im Wesentlichen frei von Wasserstoff. Dies bewirkt eine hohe thermische Stabilität der Beschichtung des erfindungsgemäßen Bauteils.

Vorteilhafte Weiterbildungen ergeben sich aus den Unteransprüchen.

Bevorzugt gilt für die kristalline keramische Matrix aus Crₓ(C_{1-y}N_{y}), dass 0,9 ≤ x ≤ 1,1 und y > 0,8 sind.

Die Kohlenstoffpartikel weisen vorzugsweise eine Größe von weniger als 10 nm, besonders bevorzugt von weniger als 5 nm auf. Je kleiner die Kohlenstoffpartikel sind, desto gleichmäßiger sind sie in der Matrix verteilt und desto besser ist der selbstschmierende Effekt.

Die Gleitschicht weist bevorzugt einen Gesamt-Kohlenstoffgehalt von 3 - 15 Atom-%, besonders bevorzugt von 5 - 10 Atom-% aufweist. Ein zu hoher Kohlenstoffgehalt würde zur Ausbildung von zu großen Kohlenstoffpartikeln oder gar zur Bildung von Kohlenstoff-Lamellen führen. Beide Effekte würden die mechanische Stabilität der Gleitschicht des erfindungsgemäßen Bauteils herabsetzen.

Die Dicke der Gleitschicht kann 1 bis 50 µm, bevorzugt 10 bis 30 µm betragen. Diese vergleichsweise großen Dicken sind darstellbar, da die Eigenspannungen der Gleitschicht des erfindungsgemäßen Bauteils relativ gering sind.

Die Vickers-Härte der Gleitschicht beträgt vorzugsweise 2000 - 3000 HV 0,05 und/oder der Elastizitätsmodul der Gleitschicht beträgt 200 - 300 GPa, um ihre Verschleißfestigkeit zu optimieren.

Die Gleitschicht weist bevorzugt eine mittlere Rautiefe Rz von weniger als 1 µm und/oder einen Materialanteil Rmr(02) von mehr als 50% und/oder dass einen Materialanteil Rmr(03) von mehr als 80%. Da die keramische Phase relativ hart ist, sollte die Oberfläche der Gleitschicht möglichst wenig Unregelmäßigkeiten aufweisen, die in einem tribologischen System auf den Gegenkörper abrasiv wirken würden. Die Definition und Bestimmung des Materialanteils Rmr sind in der Norm DIN EN ISO 4287 festgelegt.

Der Grundkörper des Bauteils kann bspw. aus Gusseisen oder Stahl bestehen.

Zwischen dem Grundkörper und der Gleitschicht ist bevorzugt eine Haftschicht aus einem metallischen Werkstoff vorgesehen. Diese besteht aus einem Metall oder einer Metalllegierung, z.B. Molybdän, Chrom, Titan, Wolfram, oder Chrom-AluminiumLegierung. Die Haftschicht dient zur Optimierung der Haftung der folgenden Schichten auf dem Grundkörper.

Zwischen der Haftschicht und der Gleitschicht ist vorzugsweise eine Zwischenschicht aus einem Metallnitrid-Werkstoff vorgesehen, bspw. Chromnitrid, Molybdännitrid, Titannitrid oder Chrom-Aluminium-Nitrid. Die Zwischenschicht fungiert als Diffusionssperre. Sie verhindert eine Diffusion von Kohlenstoff in die Haftschicht. Würde Kohlenstoff in die Haftschicht diffundieren, käme es zu einer Bildung von spröden Metallcarbiden an der Grenzzone beider Schichten. Dies hätte eine mechanische Instabilität zur Folge hätte.

Die Haftschicht und die Zwischenschicht weisen bevorzugt eine Dicke von jeweils 0,5 bis 4 µm auf. Diese Dicken sind vollkommen ausreichend, so dass ein zu hohes Endgewicht des erfindungsgemäßen Bauteils vermieden wird.

Das erfindungsgemäße Bauteil ist bevorzugt ein Bauteil für einen Verbrennungsmotor, bspw. ein Kolbenring.

Im Folgenden wird die Erfindung anhand der beigefügten Zeichnungen näher erläutert. Es zeigen in einer schematischen, nicht maßstabsgetreuen Darstellung:
- Figur 1: ein Ausführungsbeispiel eines erfindungsgemäß beschichteten Bauteils im Schnitt;
- Figur 2: ein Ausführungsbeispiel einer Vorrichtung zum Beschichten des Bauteils gemäß Figur 1;
- Figur 3: eine schematische Darstellung eines Kalottenschliffbilds des Ausführungsbeispiels gemäß Figur 1;
- Figur 4: ein Balkendiagramm eines Verschleißtests an einem erfindungsgemäß beschichteten Bauteil und an einem Vergleichsbauteil.

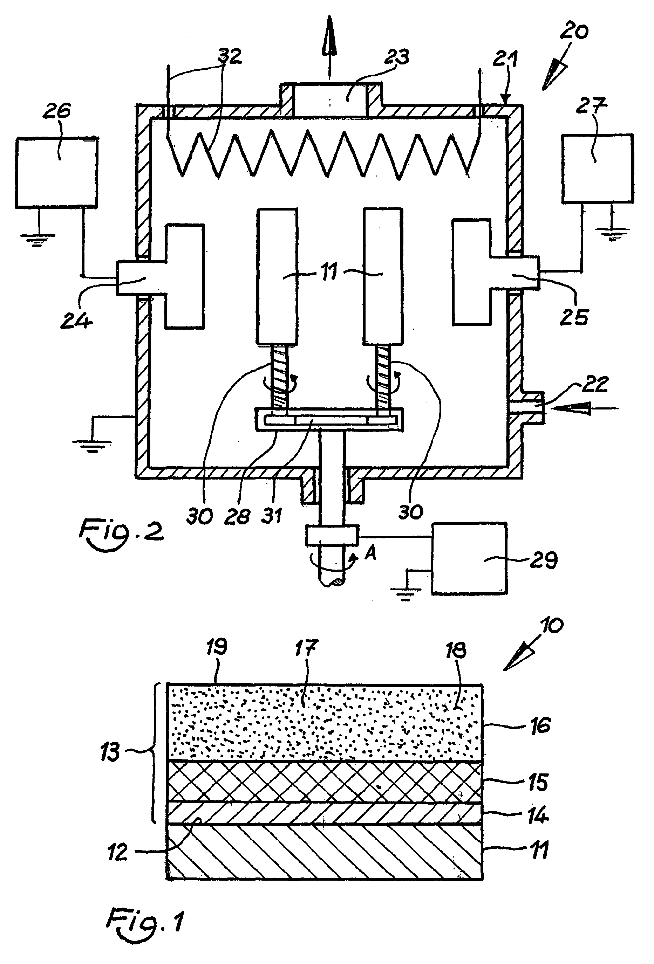

Figur 1 zeigt eine schematische Darstellung eines Ausführungsbeispiels eines erfindungsgemäß beschichteten Bauteils 10, bspw. einen Kolbenring für einen Verbrennungsmotor. Das Bauteil 10 weist einen Grundkörper 11 mit einer beschichteten Oberfläche 12 auf. Bei einem Kolbenring ist die beschichtete Oberfläche 11 die Lauffläche, die im Motorbetrieb mit der Zylinderlauffläche gleitend in Kontakt steht. Der Grundkörper 11 besteht in der Regel aus Stahl oder Gusseisen. Die Oberfläche 11 kann vor dem Beschichten in an sich bekannter Weise nitriert werden. Zur Herstellung der Beschichtung 13 wird im Ausführungsbeispiel in an sich bekannter eine Haftschicht 14 aus Chrom auf die Oberfläche 12 aufgetragen, bspw. mittels eines PVD-Verfahrens. Auf der Haftschicht 14 ist eine Zwischenschicht 15 aufgebracht, die im Ausführungsbeispiel aus Chromnitrid besteht. Auch die Zwischenschicht kann in an sich bekannter Weise mittels eines PVD-Verfahrens hergestellt werden.

Erfindungsgemäß ist auf der Zwischenschicht 15 eine Gleitschicht 16 aufgetragen. Die Gleitschicht 16 weist eine keramische Phase 17 und eine amorphe Phase 18 auf. Die keramische Phase 17 ist als kristalline keramische Matrix ausgebildet, in die kleine Partikel der amorphen Phase 18 homogen verteilt eingelagert sind. Die keramische Phase 17 besteht aus Chromcarbonitrid Crₓ( C_{1-y} N_{y} ), wobei 0,8 ≤ x ≤ 1,2 und y > 0,7 ist. Die amorphe Phase 18 besteht aus Kohlenstoffpartikeln. Bei einem Kolbenring stellt die Oberfläche 19 der Gleitschicht 16 im Motorbetrieb die Kontaktfläche dar, mit welcher der Kolbenring gleitend mit der Zylinderlauffläche in Kontakt steht und mit ihr ein tribologisches System bildet.

Zur Herstellung der Beschichtung 13, insbesondere der Gleitschicht 16, wird ein PVD-Verfahren mit Lichtbogenverdampfung verwendet. Figur 2 zeigt schematisch eine Beschichtungsanlage 20, wie sie zur Durchführung dieses Verfahren verwendet werden kann. Der Aufbau dieser Beschichtungsanlage wird nachfolgend beschrieben.

Die Beschichtungsanlage 20 gemäß Figur 2 verfügt über eine Vakuumkammer 21, die eine Gaseinlassöffnung 22 und eine Absaugöffnung 23 aufweist. An den Wänden der Vakuumkammer 21 ist eine elektrische Heizeinrichtung 32 angebracht. Die Vakuumkammer 21 selbst liegt elektrisch auf Masse.

In der Vakuumkammer 21 sind zwei Targets 24, 25 angeordnet. Das erste Target 24 besteht aus metallischem Chrom und ist mit der Kathode einer Stromquelle 26 zur Erzeugung eines Lichtbogens verbunden. Das zweite Target 25 besteht aus Kohlenstoff im Form von Graphit und ist ebenfalls der Kathode einer Stromquelle 27 zur Erzeugung eines Lichtbogens verbunden. Die Targets 24, 25 sind derart angeordnet, dass sie gleich weit von der zu beschichtenden Oberfläche 12 des Grundkörpers 11 des zu beschichtenden Bauteils entfernt sind. Wenn die Vakuumkammer 21 entsprechend groß ist, kann anstelle jeweils eines einzelnen Targets 24, 25 eine Gruppe von Targets vorgesehen sein, wobei die räumliche Anordnung so zu gestalten ist, dass der von den Targets ausgehende Ionenfluss räumlich weitgehend homogen ist.

Ein um den Pfeil A drehbarer Drehtisch 28 ist in der Mitte der Vakuumkammer 21 angeordnet und mit einer Stromquelle 29 für die Erzeugung der Biasspannung elektrisch verbunden. Der Drehtisch 28 weist mehrere, kreisförmig um seinen Mittelpunkt angeordnete Spindeln 30 auf. Auf den Spindeln 30 werden die zu beschichtenden Grundkörper 11 befestigt. Die Spindeln 30 sind drehbar gelagert und werden vom Drehtisch 28 über ein in seinem Innern vorgesehenes Planetengetriebe 31angetrieben. Das Übersetzungsverhältnis des Planetengetriebes beträgt 5 bis 7.

Im Folgenden wird das Prinzip eines PVD-Beschichtungsverfahrens mit Lichtbogenverdampfung beschrieben.

Nach der Montage der zu beschichtenden Grundkörper 11 auf den Spindeln 30 wird die Vakuumkammer 21 geschlossen und der Druck in der Vakuumkammer 21 auf 0,03 Pa oder weniger reduziert, indem Gas durch die Absaugöffnung 23 abgepumpt wird. Gleichzeitig wir die Heizeinrichtung 32 in Betrieb genommen. Die Heizeinrichtung 32 bewirkt ein Ausgasen, d.h. die Freisetzung von Gasen, die auf der Innenwand der Vakuumkammer 21 und auf den zu beschichtenden Grundkörpern 11 absorbiert sind. Nach dem Abpumpen und Ausheizen wird der Drehtisch 28 in Rotation versetzt und ein Edelgas, in der Regel Argon, durch die Gaseinlassöffnung 22 in die Vakuumkammer eingelassen. Nun werden die Targets 24 aus Chrom in Betrieb genommen. Eine negative Biasspannung von -800 bis -1200 Volt wird über die Stromquelle angelegt. Die von den Targets 24 emittierten Chromionen ionisieren ihrerseits das Argongas. Durch die hohe Biasspannung werden die Ionen stark beschleunigt, treffen mit hoher kinetischer Energie auf die Grundkörper 11 auf und schlagen aus der Oberfläche der Grundkörper 11 die obersten Atomlagen heraus, welche typischerweise aus Oxiden bestehen. Auf diese Weise wird eine Reinigung der zu beschichtenden Oberflächen 12 der Grundkörper 11 durch Ionenbeschuss durchgeführt. Dieser Vorgang wird auch als Ionenätzen bezeichnet.

Danach wird die Biasspannung auf einen niedrigen Wert eingestellt, der Argondruck wird etwas erhöht, und die Stromzufuhr für die Targets 24 aus Chrom wird erhöht. Unter diesen Bedingungen werden mehr Chromionen auf der gereinigten Oberfläche 12 der Grundkörper 11 abgeschieden als durch den Ionenbeschuss abgeätzt werden. Diese verbleibenden Chromionen bilden eine metallische Chromschicht als Haftschicht 14.

Nach einiger Zeit wird bei konstanter Stromzufuhr zu den Targets 24 aus Chrom und bei weiterhin niedriger Biasspannung das Argon durch Stickstoff ersetzt. Stickstoff stellt ein Reaktivgas dar. Innerhalb des in der Kammer brennenden Plasmas wird die N-N-Bindung der Stickstoff-Moleküle aufgebrochen. Die freien Stickstoff-Atome reagieren mit den Chromionen. Das Reaktionsprodukt wird in Form von Chromnitrid als Zwischenschicht 15 auf der Oberfläche der Haftschicht 14 abgeschieden.

Zur Sicherstellung einer guten Haftung der zu bildenden Gleitschicht auf der Zwischenschicht 15 aus Chromnitrid wird im nächsten Schritt unter den oben beschriebenen Bedingungen ein Zwischenätzen durch Ionenbeschuss durchgeführt.

Danach wird die Gleitschicht 16 abgeschieden. Zu diesem Zweck werden Stickstoff und Argon in die Vakuumkammer 21 eingelassen und sowohl die Targets 24 aus Chrom als auch die Targets 25 aus Kohlenstoff in Betrieb genommen. Die Biasspannung bleibt auf einem niedrigen Wert.

Der Drehtisch 28 wird in eine schnelle Rotation von 20 - 40 Umdrehungen pro Minute versetzt. Dies ist erforderlich, damit der freie Kohlenstoff, der nicht in der keramischen Phase 17 als Chromcarbonitrid gebunden ist, in Form diskreter Partikel homogen verteilt in der keramischen Phase 17 abgeschieden wird. Bei langsamer Drehung des Drehtisches 28 wird ein Schichtsystem in Form eines Multilamellenpakets ausgebildet, das aus einer Abfolge von keramischen Lamellen und Lamellen aus Kohlenstoff besteht. Da Lamellen aus Kohlenstoff nur schwache Bindungskräfte ausbilden, wird ein solches Lamellenpaket mechanisch relativ instabil.

Für die Einstellung des erfindungsgemäßen Gesamt-Kohlenstoffgehaltes ist das Verhältnis des Kathodenstromes für die Targets 24 aus Chrom zum Kathodenstrom für die Targets 25 aus Kohlenstoff maßgebend. Dieses Verhältnis beträgt 7 bis 13, bevorzugt 8,5 bis 11,5.

Die Zusammensetzung der keramischen Phase 17 wird im Wesentlichen durch den Stickstoffpartialdruck gesteuert. Ein hoher Stickstoffpartialdruck führt zu einem hohen Stickstoffgehalt in der keramischen Phase 17. Das Verhältnis von Stickstoffpartialdruck zu Gesamtdruck soll 0,55 bis 0,75 betragen, bevorzugt 0,6 bis 0,7.

Es ist auch möglich, die Abscheidung der Gleitschicht 16 mit Neon anstelle von Argon durchzuführen. Neon hat eine geringere Atommasse als Argon. Dies wirkt sich auf den als "Resputtering" bekannten Effekt aus. "Resputtering" bedeutet, dass die abzuscheidende Schicht während ihrer Entstehung ständig von Inertgas-Ionen beschossen wird, welche einen Teil der Schichtpartikel, insbesondere weniger fest eingebundene Partikel, wieder abtragen. Die Sputterrate hängt nun von der Masse der Inertgas-Ionen ab. Die leichten Neon-Ionen weisen gegenüber Kohlenstoff eine hohe Sputterrate und gegenüber Chrom bzw. Chromcarbonitrid eine niedrige Sputterate auf, während die Verhältnisse mit den schwereren Argon-Ionen umgekehrt sind. Mit Neon als Inertgas kann man also das Resputtering von Kohlenstoff im Verhältnis zum Resputtering von Chrom bzw. Chromcarbonitrid erhöhen und somit den Mengenanteil der eingelagerten Kohlenstoffpartikel reduzieren. Ferner führt eingelagertes Neon zu geringeren Eigenspannungen als eingelagertes Argon.

Die Gleitschicht 16 weist unter geeigneten Abscheidebedingungen moderate innere Spannungen auf und kann daher in Schichten mit einer Dicke bis zu 50 µm abgeschieden werden.

Wenn die gewünschte Schichtdicke erreicht ist, werden die elektrischen Ströme, die Heizung sowie die Gaszufuhr abgeschaltet, und man lässt die Vakuumkammer 21 samt Inhalt abkühlen. Danach kann die Vakuumkammer 21 geöffnet, und die beschichteten Bauteile 10 können entnommen werden.

Wie bei einer PVD-Beschichtung durch Lichtbogenverdampfung üblich, weist die Oberfläche der Gleitschicht 16 im Abscheidezustand eine relativ hohe Rauheit auf, die für tribologische Anwendungen ungeeignet ist. Daher wird ein abschließender Finishing-Prozess vorgenommen. Dieser kann, je nach Geometrie der Bauteile 10, durch Schleifen, Honen, Läppen, Polieren oder einer Kombination dieser Verfahren erfolgen. Wesentlich ist, eine glatte Oberfläche mit hohem Traganteil zu erzeugen.

Nachfolgend wird ein Ausführungsbeispiel der vorliegenden Erfindung beschrieben.

Es werden Kolbenringe aus nitriertem Stahl und mit trapezförmigem Querschnitt verwendet. Derartige Kolbenringe und ihre Herstellung sind an sich bekannt, bspw. aus der WO 2005/121609 A1. Vor ihrer Beschichtung werden die Kolbenringe in einem wässrigen Verfahren sorgfältig gereinigt und getrocknet. Danach werden sie in zylinderförmigen Stapeln angeordnet, mit einer Hilfsvorrichtung fixiert, und als Spindeln 30 auf die entsprechenden Plätze des Drehtisches 28 eingesetzt.

Der Drehtisch 28 wird in die Vakuumkammer 21 eingefahren und diese dann verschlossen. Danach wird die Vakuumkammer 21 auf einen Enddruck von höchstens 0,03 Pa evakuiert und auf eine Temperatur von 420°C aufgeheizt. Dies dauert 90 bis 120 Minuten. Wenn die Heiztemperatur zu niedrig ist, ist das Ausgasen unvollständig. Wenn die Heiztemperatur zu hoch ist, können sich die Kolbenringe verformen.

Diese Temperatur wird während des gesamten Verfahrensablaufs gehalten.

Das erste Ionenätzen erfolgt bei einer Biasspannung von -900 Volt und einem Argondruck von 0,08 Pa. Die Targets 24 aus Chrom werden intermittierend über eine Gesamtzeit von 12 Minuten betrieben, nämlich 30 Sekunden lang bei einem Gesamtstrom von 90 A, gefolgt von 30 Sekunden Pause. Der relativ geringe Kathodenstrom sowie die Pausen dienen dazu, ein zu starkes Aufheizen der Kolbenringe zu vermeiden. Dies würde nicht nur zu einer Verformung der Kolbenringe führen, sondern auch zu einem Denitrieren der oberflächennahen Randzone, was die Haftung der nachfolgenden Haftschicht 14 aus Chrom vermindern würde. Auch eine zu hohe Biasspannung würde die Kolbenringe zu stark aufheizen. Umgekehrt würde eine zu niedrige Biasspannung kein zufrieden stellendes Reinigungsergebnis bewirken.

Die Haftschicht 14 aus Chrom wird sodann unter 2 Pa Argondruck, -50 Volt Biasspannung und 480 A Kathodenstrom abgeschieden. Innerhalb von 60 Minuten entsteht eine Haftschicht 14 mit einer Dicke von ca. 1,5 µm.

Unter den gleichen Bedingungen, nur unter 2 Pa Stickstoffdruck anstelle des Argons, wird anschließend die Zwischenschicht 15 aus Chromnitrid gebildet. Innerhalb von 90 Minuten entsteht eine Zwischenschicht 15 mit einer Dicke von ca. 3 µm. Diese Zwischenschicht 15 fungiert unter anderem als Diffusionssperre. Würde man die Gleitschicht 16 direkt auf die metallische Haftschicht 14 aus Chrom abscheiden, so würde Kohlenstoff in die Chromschicht eindiffundieren. In der Grenzzone würden sich Chromcarbide bilden, die zu Adhäsionsproblemen führen würden. Die Zwischenschicht 15 aus Chromnitrid verhindert eine derartige Diffusion und ermöglicht eine gute, mechanisch belastbare Adhäsion der auf ihr aufgetragenen Gleitschicht 16.

Eine weitere Verbesserung der Adhäsion wird erreicht, wenn man an die Abscheidung der Zwischenschicht 15 aus Chromnitrid ein erneutes Ionenätzen anschließt, welches unter den gleichen Bedingungen wie oben beschrieben durchgeführt wird. Durch dieses Ionenätzen werden Chromnitrid-Partikel, die nur lose auf der Oberfläche liegen und die deshalb die Adhäsion beeinträchtigen können, entfernt.

Zur Abscheidung der Gleitschicht 16 werden zu den Targets 24 aus Chrom auch die Targets 25 aus Kohlenstoff in Betrieb genommen. Die folgenden Bedingungen eingestellt:

| | |
|---|---|
| Gesamter Kathodenstrom für die Chromtargets: | 800 A |
| gesamter Kathodenstrom für die Kohlenstofftargets: | 80 A |
| Biasspannung: | -50 V |
| Gesamtdruck: | 3 Pa |
| Verhältnis der Partialdrücke von Stickstoff und Argon: | 2 zu 1 |
| Drehgeschwindigkeit des Drehtischs: | 30 U/min |

In 7 Stunden wird eine Gleitschicht von ca. 18 µm Dicke abgeschieden.

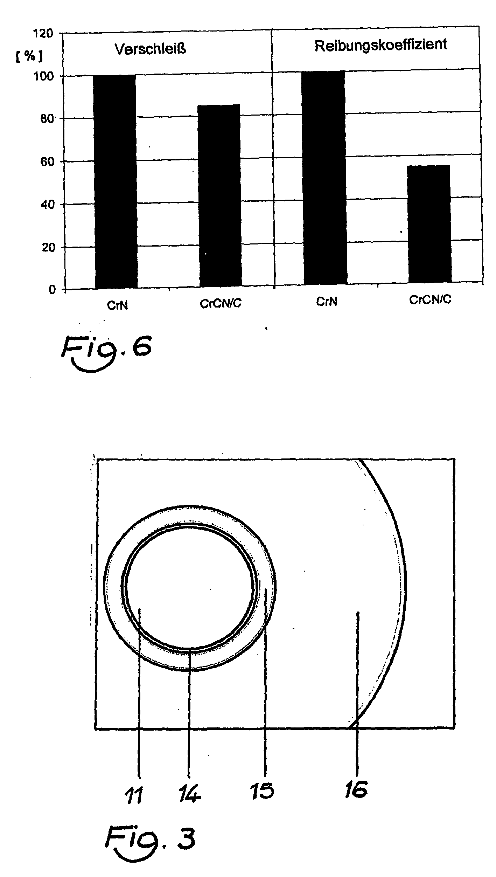

Zur Überprüfung der Schichtdicken wurde ein Kalotten-Schliffbild angefertigt, dessen schematische Darstellung in Figur 3 wiedergegeben ist. Es zeigt von innen nach außen den Grundkörper 11 aus Stahl, die Haftschicht 14 aus Chrom, die Zwischenschicht 15 aus Chromnitrid und die erfindungsgemäße Gleitschicht 16. Die Haftschicht 14 aus Chrom ist 1,3 µm dick, die Zwischenschicht 15 aus Chromnitrid ist 3,2 µm dick, und die erfindungsgemäße Gleitschicht 16 ist 18 µm dick. Das Kalotten-Schliffbild zeigt glatte Übergänge ohne Ausfransungen zwischen den einzelnen Schichten. Dies belegt eine einwandfreie Haftung der einzelnen Schichten aufeinander.

Die Messung der Vickers-Härte HV 0,05 der erfindungsgemäßen Gleitschicht 16 wurde in an sich bekannter Weise durchgeführt und ergab einen Wert von 2400 HV 0,05. Mittels des an sich bekannten Last-Eindringverfahrens wurde der E-Modul der erfindungsgemäßen Gleitschicht 16 bestimmt. Dabei ergab sich ein Wert von 280 GPa.

Die Zusammensetzung der erfindungsgemäßen Gleitschicht 16 wurde in an sich bekannter Weise mithilfe der Glimmlampen-Emissionsspektrometrie analysiert. Dabei wurden die nachfolgenden Werte ermittelt: Chromgehalt 47 Atom-%, Stickstoffgehalt 47 Atom-%, Gesamt-Kohlenstoffgehalt 6 Atom-%.

Das Endbearbeiten der Kolbenringe erfolgt in einer Kombination von Feinschleifen und Läppen. Zum Feinschleifen wird ein Korund-Schleifpapier mit einer Körnung von 500 eingesetzt. Danach schließt sich ein Läppen mit Diamantpaste von 0,5 µm Körnung an.

Die Auswertung der Oberflächen-Kenngrößen nach DIN EN ISO 4287 ergab eine gemittelte Rautiefe Rz von 0,09, einen Wert für den Materialanteil Rmr 02 von 57% sowie einen Wert für den Materialanteil Rmr 03 von 85 %.

Nach dem Feinschleifen und Läppen wurde zur Überprüfung der Schichthaftung ein so genannter Scratchtest durchgeführt. Dabei wird die Gleitschicht 16 mit einer Diamantspitze gekratzt, die in gerader Bahn über eine Länge von 4 mm über die Oberfläche der Gleitschicht 16 geführt wird. Die Last steigt dabei von Null auf 180 N an, so dass die Diamantspitze immer tiefer in die Gleitschicht 16 eindringt. Bei einer bestimmten Last lässt sich die Gleitschicht 16 nicht weiterverformen und platzt ab. Diese Last wird kritische Last genannt. Je höher die kritische Last ist, desto höher ist die Haftung beziehungsweise die Verformbarkeit der Gleitschicht 16. Die Versuche ergaben, dass bei einer kritischen Last von ca. 117 N die Gleitschicht 16 abzuplatzen beginnt. Dies ist für eine derartige Gleitschicht ein sehr guter Wert.

Die Schichtstruktur wurde mittels hoch auflösender Transmissions-Elektronenspektroskopie untersucht. Die Gleitschicht 16 zeigte im Hellfeld-Bild keinen lamellaren Schichtaufbau, sondern eine homogene Morphologie.

Eine Dunkelfeldaufnahme für Kohlenstoff desselben Bereichs der Gleitschicht 16 zeigte Kohlenstoff-Partikel mit einer Größe unter 10 nm. Diese sind als amorphe Phase 18 weitgehend gleichmäßig in der als kristalline keramische Matrix ausgebildeten keramischen Phase 17 verteilt (vgl. Figur 2).

Für einen Vergleichstest wird als Vergleichsbeispiel ein Kolbenring mit einer herkömmlichen Chromnitrid-Schicht herangezogen, der ähnlich wie das Ausführungsbeispiel hergestellt wird. Kolbenringe aus nitriertem Stahl werden wie oben beschrieben gereinigt, in die Vakuumkammer 21 eingesetzt, geätzt und mit einer Haftschicht aus Chrom versehen. Die Chromnitrid-Schicht wird unter den gleichen Bedingungen wie beim Ausführungsbeispiel abgeschieden. Lediglich die Beschichtungszeit wird auf 10 Stunden verlängert. Dabei entsteht eine Chromnitrid-Schicht mit einer Dicke von 20 µm und einer Vickers-Härte von ca. 1200 HV 0,05. Diese Schicht wird in analoger Weise wie oben beschrieben mittels Feinschleifen und Läppen endbearbeitet.

Für die Messung der Verschleißbeständigkeit der Kolbenringe gemäß dem Ausführungsbeispiel bzw. gemäß dem Vergleichsbeispiel wurde ein an sich bekanntes Tribometer eingesetzt, das einen reversierenden Gleitverschleiß erzeugt. Als Prüfteile kamen Segmente eines erfindungsgemäß beschichteten Kolbenrings mit Gleitschichten gemäß Figur 1 und Segmente eines gemäß dem Vergleichsbeispiel beschichteten Kolbenrings zum Einsatz. Als Gegenkörper kamen Segmente eines dazu korrespondierenden gehonten Zylinders aus lamellarem Gusseisen zum Einsatz. Mit dieser Prüfanordnung wurde die Bewegung des Kolbenrings im Zylinder abgebildet, und zwar im verschleißrelevanten Bereich des oberen Umkehrpunkts. Dementsprechend wurden die Prüfbedingungen so gewählt, dass bei langsamerer Bewegung und geringstem Schmierölangebot eine hohe Last und damit eine hohe Flächenpressung auf die Versuchsanordnung wirkten, entsprechend dem auf dem Kolbenring im Motorbetrieb lastenden Gasdruck. Die Prüfbedingungen waren im Einzelnen:

| | |
|---|---|
| Testdauer: | 12 Stunden |
| Last: | 1.200 N |
| Flächenpressung: | 57 N/mm² |
| Hub: | 4 mm |
| Geschwindigkeit: | 1,33 m/min |
| Frequenz: | 5 Hz |
| Schmierung: | 0,036g alle 2 Stunden |
| Öl: | Motoröl 5 W 40 |
| Temperatur: | 20°C |

Während des Verschleißtests wurden die dabei auftretenden Reibkräfte gemessen und daraus die Reibungskoeffizienten errechnet. Nach dem Test wurde die Verschleißtiefe an den Kolbenringen und den Gegenkörpern ausgewertet. Diese waren zum Teil sehr gering, so dass ein Weißlicht-Interferometer zur Bestimmung der Profiltiefe eingesetzt wurde.

Bei der Auswertung der Messergebnisse diente die Paarung Chromnitrid - lamellares Gusseisen als Vergleichsbeispiel nach dem Stand der Technik und als Referenz zur Normierung der Daten. Die resultierende Figur 4 zeigt den Vergleich der Werte für Verschleiß und Reibung als Balkendiagramm. Daraus ist zu entnehmen, dass die erfindungsgemäße Gleitschicht 16 gegenüber einer herkömmlichen Chromnitrid-Schicht eine etwas verbesserte Verschleißbeständigkeit und einen deutlich erniedrigten Reibungskoeffizienten aufweist.

Die thermische Beständigkeit der erfindungsgemäßen Gleitschicht 16 wurde geprüft, indem mit einer erfindungsgemäßen Gleitschicht versehene Kolbenringe in Luft bei einer Temperatur von 500°C über 6 Stunden ausgelagert wurden. Danach wurde die ausgelagerte Gleitschicht im Vergleich zu einer nicht ausgelagerten Gleitschicht untersucht. Dazu wurden zwei Methoden verwendet. Zum einen wurde jeweils ein Kalottenschliff angefertigt und anschließend das Aussehen der Gleitschicht unter dem Mikroskop betrachtet. Zum anderen wurden die Gleitschichten mittels Röntgendiffraktometrie untersucht.

Im Kalottenschliff ergaben sich keinerlei Unterschiede in der Schichtmorphologie.

Auch die Röntgendiffraktometrie ergab keine Unterschiede bei den Beugungsreflexen. Damit ist gezeigt, dass bei der thermischen Auslagerung keinerlei Umwandlungen oder Festkörperreaktionen stattgefunden haben. Die erfindungsgemäße Gleitschicht ist bei einer Temperatur von 500°C thermisch stabil.

## Patentansprüche

1. Bauteil (10) mit einer Chrom, Stickstoff und Kohlenstoff enthaltenden Beschichtung (13), **dadurch gekennzeichnet, dass** die Beschichtung (13) eine Gleitschicht (16) mit einer keramischen Phase (17) und einer amorphen Phase (18) aufweist, dass die keramische Phase (17) eine kristalline keramische Matrix aus Crₓ(C_{1-y}N_{y}) mit 0,8 ≤ x ≤ 1,2 und y > 0,7 bildet, und dass die amorphe Phase (18) aus Kohlenstoffpartikeln besteht, die in die kristalline keramische Matrix (17) im Wesentlichen gleichmäßig verteilt eingelagert sind.

2. Bauteil nach Anspruch 1, **dadurch gekennzeichnet, dass** für die kristalline keramische Matrix (17) aus Crₓ(C_{1-y}N_{y}) gilt: 0,9 ≤ x ≤ 1,1 und y > 0,8.

3. Bauteil nach Anspruch 1, **dadurch gekennzeichnet, dass** die Kohlenstoffpartikel eine Größe von weniger als 10 nm aufweisen.

4. Bauteil nach Anspruch 3, **dadurch gekennzeichnet, dass** die Kohlenstoffpartikel eine Größe von weniger als 5 nm aufweisen.

5. Bauteil nach Anspruch 1, **dadurch gekennzeichnet, dass** die Gleitschicht (16) einen Gesamt-Kohlenstoffgehalt von 3 - 15 Atom-% aufweist.

6. Bauteil nach Anspruch 5, **dadurch gekennzeichnet, dass** die Gleitschicht (16) einen Gesamt-Kohlenstoffgehalt von 5 - 10 Atom-% aufweist.

7. Bauteil nach Anspruch 1, **dadurch gekennzeichnet, dass** die Dicke der Gleitschicht (16) 1 - 50 µm beträgt.

8. Bauteil nach Anspruch 1, **dadurch gekennzeichnet, dass** die Vickers-Härte der Gleitschicht (16) 2000 - 3000 HV 0,05 beträgt.

9. Bauteil nach Anspruch 1, **dadurch gekennzeichnet, dass** der Elastizitätsmodul der Gleitschicht (16) 200 - 300 GPa beträgt.

10. Bauteil nach Anspruch 1, **dadurch gekennzeichnet, dass** die Gleitschicht (16) eine mittlere Rautiefe Rz von weniger als 1 µm aufweist und/oder dass der Materialanteil Rmr(02) mehr als 50% beträgt und/oder dass der Materialanteil Rmr(03) mehr als 80% beträgt.

11. Bauteil nach Anspruch 1, **dadurch gekennzeichnet, dass** es einen Grundkörper (11) aus Gusseisen oder Stahl aufweist.

12. Bauteil nach Anspruch 11, **dadurch gekennzeichnet**, zwischen dem Grundkörper (11) und der Gleitschicht (16) eine Haftschicht (14) aus einem metallischen Werkstoff aufgebracht ist.

13. Bauteil nach Anspruch 12, **dadurch gekennzeichnet, dass** zwischen der Haftschicht (14) und der Gleitschicht (16) eine Zwischenschicht (15) aus einem Metallnitrid-Werkstoff aufgebracht ist.

14. Bauteil nach Anspruch 1, nämlich ein Kolbenring für einen Verbrennungsmotor.

15. Verfahren zum Beschichten eines Bauteils (10) mit einer Gleitschicht (16), wobei mindestens ein Bauteil (10) in einer Vakuumkammer (21) drehbar auf einer auf einem Drehtisch (28) angeordneten Spindel (30) montiert ist, **dadurch gekennzeichnet, dass** zur Herstellung der Gleitschicht (16) ein PVD-Verfahren mit Lichtbogenverdampfung mit den folgenden Parametern verwendet wird:
Werkstoffquellen: mindestens ein Metalltarget (24) und mindestens ein Kohlenstofftarget (25);
Verhältnis der Targetströme Metall zu Kohlenstoff: 7 bis 13;
Abscheidetemperatur am Bauteil (10): 350°C bis 450°C;
Biasspannung: 0 bis -100 V;
Druck in der Vakuumkammer: 2 - 4 Pa;
Atmosphäre in der Vakuumkammer: Stickstoff und Inertgas mit einem Verhältnis des Stickstoffpartialdrucks zum Gesamtdruck von 0,55 bis 0,75;
Rotation des Drehtisches (28): 20 - 40 Umdrehungen pro Minute Rotation der mindestens einen Spindel (30): 5 - 7 Umdrehungen pro einer Umdrehung des Drehtischs (28).

## Claims

1. Component (10) having a coating (13) containing chromium, nitrogen and carbon, **characterised in that** the coating (13) comprises a sliding layer (16) having a ceramic phase (17) and an amorphous phase (18), **in that** the ceramic phase (17) forms a crystalline ceramic matrix from Crₓ(C_{1-y}N_{y}) with 0.8 ≤ x ≤ 1.2 and y > 0.7, and **in that** the amorphous phase (18) consists of carbon particles, which are embedded in the crystalline ceramic matrix (17) substantially uniformly spread.

2. Component according to claim 1, **characterised in that** for the crystalline ceramic matrix (17) made from Crₓ(C_{1-y}N_{y}): 0.9 ≤ x ≤ 1.1 and y > 0.8

3. Component according to claim 1, **characterised in that** the carbon particles have a size of less than 10 nm.

4. Component according to claim 3, **characterised in that** the carbon particles have a size of less than 5 nm.

5. Component according to claim 1, **characterised in that** the sliding layer (16) has a total carbon content of 3 to 15 at.%.

6. Component according to claim 5, **characterised in that** the sliding layer (16) has a total carbon content of 5 to 10 at.%.

7. Component according to claim 1, **characterised in that** the thickness of the sliding layer (16) is 1 to 50 µm.

8. Component according to claim 1, **characterised in that** the Vickers hardness of the sliding layer (16) is 2000 - 3000 HV 0.05

9. Component according to claim 1, **characterised in that** the modulus of elasticity of the sliding layer (16) is 200 to 300 GPa.

10. Component according to claim 1, **characterised in that** the sliding layer (16) has an average surface roughness Rz of less than 1 µm, and/or that the material portion Rmr(02) is greater than 50% and/or that the material portion Rmr(03) is greater than 80%.

11. Component according to claim 1, **characterised in that** it comprises a main body (11) made from cast iron or steel.

12. Component according to claim 11, **characterised in that** a bonding layer (14) made from a metallic material is applied between the main body (11) and the sliding layer (16).

13. Component according to claim 12, **characterised in that** an intermediate layer (15) made from a metal nitride material is applied between the bonding layer (14) and the sliding layer (16).

14. Component according to claim 1, in particular a piston ring for an internal combustion engine.

15. Method for coating a component (10) with a sliding layer (16), wherein at least one component (10) is rotatably mounted on a spindle (30) arranged on a turntable (28) in a vacuum chamber (21), **characterised in that** in order to produce the sliding layer (16), a PVD method comprising arc evaporation is employed, having the following parameters: material source: at least one metal target (24) and at least one carbon target (25); ratio of the metal to carbon target flows: 7 to 13; deposition temperature on the component (10): 350°C bis 450°C; bias voltage: 0 to -100 V; pressure in the vacuum chamber: 2 to 4 Pa; atmosphere in the vacuum chamber: nitrogen and inert gas with a ratio between the nitrogen partial pressure and the total pressure of 0.55 to 0.75; turntable (28) rotation: 20 to 40 revolutions per minute; rotation of the at least one spindle (30): 5 to 7 revolutions per one revolution of the turntable (28).

## Revendications

1. Composant (10) comprenant un revêtement (13) contenant du chrome, de l'azote et du carbone, **caractérisé en ce que** le revêtement (13) présente une couche de glissement (16) présentant une phase céramique (17) et une phase amorphe (18), **en ce que** la phase céramique (17) forme une matrice céramique cristalline composée de Crₓ(C_{1-y}N_{y}) où 0,8 ≤ x ≤ 1,2 et y > 0,7, et **en ce que** la phase amorphe (18) est constituée de particules de carbone, qui sont incorporées selon une répartition sensiblement homogène dans la matrice céramique cristalline (17).

2. Composant selon la revendication 1, **caractérisé en ce que** s'applique pour la matrice céramique cristalline (17) composée de Crₓ(C_{1-y}N_{y}) : 0,9 ≤ x ≤ 1,1 et y > 0,8.

3. Composant selon la revendication 1, **caractérisé en ce que** les particules de carbone présentent une taille inférieure à 10 nm.

4. Composant selon la revendication 3, **caractérisé en ce que** les particules de carbone présentent une taille inférieure à 5 nm.

5. Composant selon la revendication 1, **caractérisé en ce que** la couche de glissement (16) présente une teneur totale en carbone de 3 - 15 % en atomes.

6. Composant selon la revendication 5, **caractérisé en ce que** la couche de glissement (16) présente une teneur totale en carbone de 5 - 10 % en atomes.

7. Composant selon la revendication 1, **caractérisé en ce que** l'épaisseur de la couche de glissement (16) est de 1 - 50 µm.

8. Composant selon la revendication 1, **caractérisé en ce que** la dureté de Vickers de la couche de glissement (16) est de 2000 - 3000 HV 0,05.

9. Composant selon la revendication 1, **caractérisé en ce que** le module d'élasticité de la couche de glissement (16) est de 200 - 300 GPa.

10. Composant selon la revendication 1, **caractérisé en ce que** la couche de glissement (16) présente une profondeur de rugosité moyenne Rz inférieure à 1 µm, et/ou **en ce que** la proportion en matériau Rmr(02) est supérieure à 50 %, et/ou **en ce que** la proportion en matériau Rmr(03) est supérieure à 80 %.

11. Composant selon la revendication 1, **caractérisé en ce qu'**il présente un corps de base (11) en fonte ou en acier.

12. Composant selon la revendication 11, **caractérisé en ce qu'**une couche adhésive (14) composée d'un matériau métallique est appliquée entre le corps de base (11) et la couche de glissement (16).

13. Composant selon la revendication 12, **caractérisé en ce qu'**une couche intermédiaire (15) composée d'un matériau à base de nitrure métallique est appliquée entre la couche adhésive (14) et la couche de glissement (16).

14. Composant selon la revendication 1, à savoir segment de piston pour un moteur à combustion interne.

15. Procédé pour revêtir un composant (10) d'une couche de glissement (16), dans lequel au moins un composant (10) est monté dans une chambre sous vide (21) de manière à pouvoir tourner sur une broche (30) disposée sur un plateau tournant (28), **caractérisé en ce qu'**est utilisé, afin de fabriquer la couche de glissement (16), un procédé de dépôt physique en phase vapeur (PVD) avec une évaporation d'arc électrique présentant les paramètres suivants :
sources de matériau : au moins une cible métallique (24) et au moins une cible de carbone (25) ;
rapport des flux cibles métal par rapport au carbone : 7 à 13 ;
température de dépôt au niveau du composant (10) : 350 °C à 450 °C ;
tension de polarisation : 0 à -100 V ;
pression dans la chambre sous vide : 2 - 4 Pa ;
atmosphère dans la chambre sous vide : azote et gaz inerte présentant un rapport entre la pression partielle d'azote et la pression totale de 0,55 à 0,75 ;
rotation du plateau tournant (28) : 20 - 40 tours par minute rotation de l'au moins une broche (30) : 5 - 7 tours par tour du plateau tournant (28).
